# EUROPEAN PATENT APPLICATION

(11) **EP 2 249 412 A1**
(43) Date of publication of application: **10.11.2010**
(21) Application number: 09159689.0
(22) Date of filing: 07.05.2009
(51) Int. Cl.: H01L 51/52

(54) **Organic semiconductor device and method for manufacturing the same**

(71) Applicant: Nederlandse Organisatie voor Toegepast -Natuurwetenschappelijk Onderzoek TNO, 2628 VK Delft (NL)
(72) Inventor: Wilson, Joanne Sarah, 3311 GV Dordrecht (NL); Hermes, Dorothee Christine, 5582 JZ Waalre (NL); Rensing, Petrus Alexander, 5624 ER Eindhoven (NL); van Heck, Gerardus Titus, 5627 CS Eindhoven (NL); van Mol, Antonius Maria Bernardus, 5658 HC Eindhoven (NL)
(74) Representative: Hatzmann, Martin

(57) **Abstract**

A semiconductor device is disclosed comprising:
- a first electrically conductive structure (10) that comprises at least a first electrode layer (12),
- a second electrically conductive structure (20) that comprises at least a second electrode layer (24),
- an active structure (30) that comprises at least a layer of an organic semiconducting material, the active structure being arranged between the first and the second electrically conductive structure (10, 20),
- an first electrically insulating barrier structure (40) that comprises at least an electrically insulating barrier layer arranged between the first and the second electrically conductive structure,
- a second electrically insulating barrier structure (50). The second electrically insulating barrier structure (50) extends over a part of the second electrically conductive structure (20) so that the second electrically conductive structure (20) extending laterally beyond the second electrically insulating barrier structure (50). The active structure (30) is encapsulated by an encapsulation comprising at least the first electrically conductive structure (10), the first electrically insulating barrier structure (40), the second electrically conductive structure (20) and the second electrically insulating barrier structure (50).

## Description

### BACKGROUND OF THE INVENTION

### Field of the invention

The present invention relates to an organic semiconductor device.

The present invention further relates to a method of manufacturing an organic semiconductor device.

### Related Art

A new generation of organic thin film based devices, such as organic light-emitting diodes (OLEDs) for lighting and displays, thin film batteries, thin film organic solar cells, electrochromic foils, electrophoretic displays, etc., have the potential to become a next revolution in electronic systems.

An OLED comprises a light-emitting organic film that is formed between an electrode and a counter electrode. Usually the light-emitting organic film is part of a stack that may comprise additional layers, such as a hole transport layer, an electron block layer, an electron transport layer and a luminescent layer.

In the document U.S. Pat. No. 6,835,470 an organic light-emitting diode on a metal foil is proposed.

Various materials applied in OLEDs and other organic devices are sensitive to moisture and oxygen in the atmosphere. Accordingly a barrier layer is required that protects these materials. Nevertheless it is desirable that the electrodes are connectable to external powerlines, e.g. to connect them to an external power supply in case of an OLED or an electrochromic device, or to derive a generated current generated by a photovoltaic device. The electrical conductors should pass from outside the barrier layer to inside the barrier layer in a gastight way. The cited document does not disclose how an electrical connection can be made in the presence of an encapsulation by a barrier layer.

### SUMMARY OF THE INVENTION

According to a first aspect of the invention a semiconductor device is provided comprising:
- a first electrically conductive structure that comprises at least a first electrode layer,
- a second electrically conductive structure that comprises at least a second electrode layer,
- an active structure that comprises at least a layer of an organic semiconducting material, the active structure being arranged between the first and the second electrically conductive structure,
- an first electrically insulating barrier structure that comprises at least an electrically insulating barrier layer arranged between the first and the second electrically conductive structure,
- a second electrically insulating barrier structure that extends over a part of the second electrically conductive structure, the second electrically conductive structure extending laterally beyond the second electrically insulating barrier structure, the active structure being encapsulated by an encapsulation comprising at least the first electrically conductive structure, the first electrically insulating barrier structure, the second electrically conductive structure and the second electrically insulating barrier structure.
In the device according to the invention the second electrically conductive structure extends laterally beyond the second electrically insulating barrier layer so that it can be electrically connected to the external power source. The active structure is encapsulated by an encapsulation comprising at least the first electrically conductive structure, the first electrically insulating barrier layer, the second electrically conductive structure and the second electrically insulating barrier structure. The first electrically conductive structure may be formed by a metal foil that can be directly connected to the power supply and also forms a barrier layer. In this way electrical connections to the electrodes of the OLED are provided while providing for a barrier against substances in the environment such as moisture and oxygen that could damage the materials used in the organic semiconductor device.

The at least one electrically insulating barrier layer comprises for example a layer of an inorganic, material, in particular a ceramic material, including but not limited to a metal oxide or nitride, such as silicon nitride (SiN), silicon oxide, or aluminum oxide.

In an embodiment the second electrode layer forms the electrical feed-through connection. This may be the case if the material of the electrode layer is itself resistant against the above-mentioned substances, e.g. Ag.

Often however materials may be used for the electrode layer that are not resistant against moisture and oxygen, such as Ba. In that case it is favorable if the second electrically conductive structure further comprises an electrically conductive feed-through layer that forms an electric supply structure, having a first portion covered by the second electrically insulating barrier layer and a second portion left free by the second electrically insulating barrier layer.

In an embodiment a conducting charge injection layer is arranged between the first electrically conductive structure and the active structure. The conductive layer, such as a hole injection layer (HIL), for example a PEDOT polymer layer, serves both as a planarization layer and as a buffer layer that improves hole injection. A patterned deposition technique could be used to ensure that the conducting polymer does not make electrical contact with the second electrically conductive structure.

In an embodiment the conductive charge injection layer has a thickness in the range of 10-50nm. In this range the conductive charge injection layer provides for a sufficient charge injection, while having a low lateral conductivity. A low lateral conductivity is important to prevent that a significant bypass current flows through the conductive charge injection layer if it inadvertently overlaps the second electrically conductive structure.

In an embodiment the first electrically insulating barrier structure is formed by an oxidized portion of the first electrically conductive structure. For example an aluminum layer may be provided with an aluminum oxide structure by local oxidation of the aluminum layer. This may be realized by a standard industrial process wherein the metal foil is covered with a mask (for example a photoresist) and subsequently submerged in an electrochemical bath. The exposed portion of the metal foil is then oxidized by applying a voltage (i.e. anodizing process). This process is relatively cheap as compared to a deposition of insulating layers in a vacuum process. Even a relatively thin oxide layer (e.g. in the range of 25 to 100 nm, e.g. 50 nm) should be sufficient for electrical insulation purposes as the devices only need to operate in a relatively low voltage range (0-15 V). As the first electrically insulating barrier structure merely needs to provide a lateral barrier against moisture it is presumed that a sufficiently electrically insulating layer also has sufficient barrier properties in this respect. Apart from the above-mentioned anodizing process different options are available to grow aluminium oxide layers to control these properties.

Most preferred as the first electrically insulating barrier structure is an electrical insulator structure that comprises at least one of silicon oxide (O) and silicon nitride (N). In particular a good barrier is formed by a stack of alternating layers of silicon oxide (O) and silicon nitride (N). Such a structure is also suitable as the second electrically insulating barrier structure. Alternatively the second electrically insulating barrier structure may comprise a stack comprising a plurality of inorganic layers that are mutually separated by an organic layer.

In an embodiment of the semiconductor device according to the present invention, a patterned electrically insulating layer is applied between the first and the second electrically conductive structure, and this electrically insulating layer covers a part of the surface of the first electrically conductive structure that is left free by the electrically insulating barrier layer. The patterned electrically insulating layer forms a pattern of openings through which current is conducted between the electrically conductive structures and through the active structure, so that during operation a light pattern defined by the patterned insulating layer becomes visible. In an embodiment the patterned electrically insulating layer is a patterned photoresist layer. In this way a very detailed pattern may be obtained.

In an embodiment a substrate forms the first electrically conductive structure. Metal (or metal-coated) substrates have a variety of advantages in addition to their high electrical conductivity which can be put to use in the device. Firstly, metallic substrates can be manufactured relatively inexpensively depending on the circumstances. Secondly, the high thermal conductivity of metallic substrates can contribute towards a good discharge transport of the heat. Thirdly, metallic substrates can be executed relatively thin and are flexible as a result. Fourthly the metal substrate (or metal coating on the substrate) can act as a barrier against water and oxygen penetration on one side of the device, removing the need to deposit an expensive barrier layer on this side.

According to a second aspect of the invention there is provided a method for manufacturing a semiconductor device comprising the steps of
- (S1) providing a first electrically conductive structure that comprises at least a first electrode layer,
- (S2) providing a first electrically insulating barrier structure that comprises at least an electrically insulating barrier layer on said first electrically conductive structure,
- (S3) depositing an active structure comprising at least a layer of an organic semiconducting material at the first electrically conductive structure,
- (S4) depositing on the active structure a second electrically conductive structure that comprises at least a second electrode layer,
- (S5) depositing a second electrically insulating barrier structure over the second electrically conductive structure, so that at least a portion of the second electrically conductive structure remains uncovered and forms a feed-through to the second electrode layer.

### BRIEF DESCRIPTION OF THE DRAWINGS

These and other aspects are described in more detail with reference to the drawing. Therein:
FIG. 1 shows a first embodiment of a semiconductor device according to the present invention,
Figure 2A to 2E show subsequent steps of a method for manufacturing the semiconductor device of Figure 1,
Figure 3 shows a second embodiment of a semiconductor device according to the present invention,
Figure 4 shows a top view of the semiconductor device according to IV in Figure 3,
Figure 5A to 5F show subsequent steps of a method to manufacture the device of Figure 3 and 4,
Figure 6 shows a third embodiment of a semiconductor device according to the present invention,
Figure 7 shows a fourth embodiment of a semiconductor device according to the present invention,
Figure 7A shows a cross-section according to VIIA-VIIA in Figure 7.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.
Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.. In case of conflict, the present specification, including definitions, will control. In addition, the materials, methods, and examples are illustrative only and not intended to be limiting.

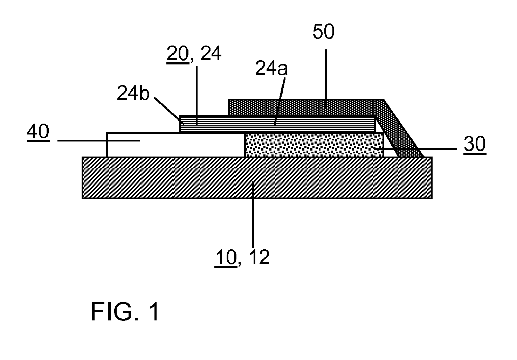

FIG. 1 shows a first embodiment of a semiconductor device according to the present invention. The device comprises a first electrically conductive structure 10. The electrically conductive structure comprises a metal foil (or metal-coated foil) such as steel, stainless steel or an aluminum foil having a thickness of 20 to 200 µm. The metal foil 10 forms a first electrode layer 12. The semiconductor device further comprises a second electrically conductive structure 20 that comprises at least a second electrode layer 24. In the embodiment shown the second electrode layer 24 is formed by a silver layer having a thickness in the range of 10 -20 nm. If the second electrode layer 24 is less than 10 nm, then relatively large resistive losses will occur in this layer 24. If the thickness of the second electrode layer 24 is substantially greater than 20 nm, e.g. greater than 40 nm, a relatively high loss of light occurs in this layer 24.

The semiconductor device further comprises an active structure 30 that comprises at least a layer of an organic semiconducting material, such as a light-emitting polymer. The active structure is arranged between the first and the second electrically conductive structures 10, 20. Depending on its function, the active structure 30 may comprise one or more functional layers. For example in the case that the electronic device is an OLED, the active structure comprises at least one layer of a light-emitting material, such as polymeric PPV or layer stacks and mixtures of small molecules possibly including phosphorescent emitters such as Ir(ppy)₃ . In addition to the active structure additional layers may be present, such as a hole injection layer (HIL) such as PEDOT between the layer of light-emitting material and the electrically conductive structure comprising the anode, and or an electron injection layer such as TPBI, TAZ, OXD7, or the like between the layer of light-emitting material and the electrically conductive structure comprising the cathode. In the embodiment shown the first electrically conductive structure 10 functions as anode and also forms an external contact 12. The second electrically conductive structure 20 comprises a first portion 24a that forms a cathode and a second portion 24b that forms an external contact to the cathode 24a.

Beside the active structure 30, i.e. in a plane defined by the active structure 30, a first electrically insulating barrier structure 40 is arranged between the first and the second electrically conductive structures 10, 20. The first electrically insulating barrier structure 40 comprises at least an electrically insulating barrier layer, e.g. an oxide layer or a nitride layer, or a stack of oxide and nitride layers that, alternate each other.

A second electrically insulating barrier structure 50 is provided that extends over a part 24a of the second electrically conductive structure 20 formed by the electrode layer 24. A portion 24b of the electrode layer that forms the second electrically conductive structure 20 extends laterally beyond the second electrically insulating barrier structure 50. The active structure 30 is encapsulated by an encapsulation comprising at least the first electrically conductive structure 10, the first electrically insulating barrier structure 40, the second electrically conductive structure 20 and the second electrically insulating barrier structure 50.

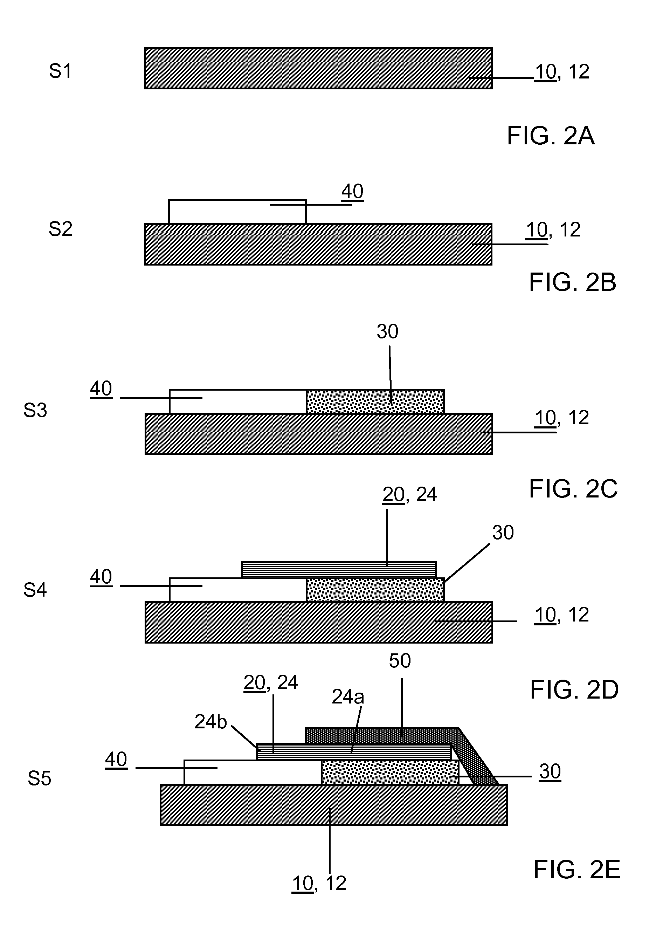

FIG. 2A to 2E show a method of manufacturing a semiconductor device as shown in Figure 1.

In step S1 illustrated in Figure 2A the first electrically conductive structure 10 is provided e.g. in the form of a metal foil. Alternatively a polymer or glass substrate may be provided having a metal layer as the first electrically conductive structure material. Also an electrically conductive polymer foil may be used as the first electrically conductive structure. The first electrically conductive structure 10 forms a first electrode layer 12. Nevertheless additional electrically conductive layers may be provided in the first electrically conductive structure 10.

Figure 2B illustrates a second step S2 wherein a first electrically insulating barrier structure 40 is provided that comprises at least an electrically insulating barrier layer on said first electrically conductive structure 10. Several options are possible to deposit the first electrically insulating barrier structure 40.

Inorganic layers forming the first electrically insulating barrier structure may be applied by all kinds of physical vapour deposition methods such as thermal evaporation, e-beam evaporation, sputtering, magnetron sputtering, reactive sputtering, reactive evaporation, etc. and all kinds of chemical vapour deposition methods such as thermal chemical vapour deposition (CVD), photo assisted chemical vapour deposition (PACVD), plasma enhanced chemical vapour deposition (PECVD), etc.

A mask layer may be used to apply the first electrically insulating barrier structure 40. For example subsequently a mask layer is applied, at least one layer of an electrically insulating barrier material is deposited and the mask layer is removed. Accordingly a first electrically insulating barrier structure 40 remains at the portions of the first electrically conductive structure 10 that were uncovered by the mask layer. The mask layer is for example a patterned photoresist layer that is applied by lithographic techniques. Alternatively the mask layer may be a polymer layer that is patterned by imprinting.

Another option is to apply first a layer of an electrically insulating barrier material at the first electrically conductive structure and to apply a mask layer at the layer of electrically insulating barrier material. In a subsequent step the electrically insulating barrier material is etched at those portions left free by the mask layer, therewith obtaining the electrically insulating barrier structure. The mask layer may be removed afterwards, e.g. with a solvent.

According to again another option the first electrically insulating barrier structure 40 is applied by locally oxidizing the first electrically conductive structure 10.

In step S3, shown in Figure 2C, the active structure 30 comprising at least a layer of an organic semiconducting material is deposited at the first electrically conductive structure 10. The at least one layer may be deposited for example by a printing method, such as inkjet printing, gravure printing, flexographic printing, screen printing, rotary screen printing, etc or by a coating technique such as bar coating, slot-die coating or spin coating. For depositing insoluble small molecules thermal evaporation or other vapour phase deposition techniques may be used. Also other methods, e.g. methods involving a carrier gas are applicable.

In step S4, as shown in Figure 2D, a second electrically conductive structure 20 that comprises at least a second electrode layer 24 is deposited on the active structure 30. The second electrode layer, the cathode in this case, is for example a layer of Ag. This layer may be applied by various techniques including thermal evaporation, printing and coating techniques, lamination of a metal layer or the use of ionic liquids.

In step S5, shown in Figure 2E, a second electrically insulating barrier structure 50 is deposited over the second electrically conductive structure 20. The electrically insulating barrier structure 50 is deposited using a suitable mask such that at least a portion 24b of the second electrically conductive structure 20 remains uncovered and forms a feed-through to the second electrode layer 24.

Therewith the product of Figure 1 is obtained.

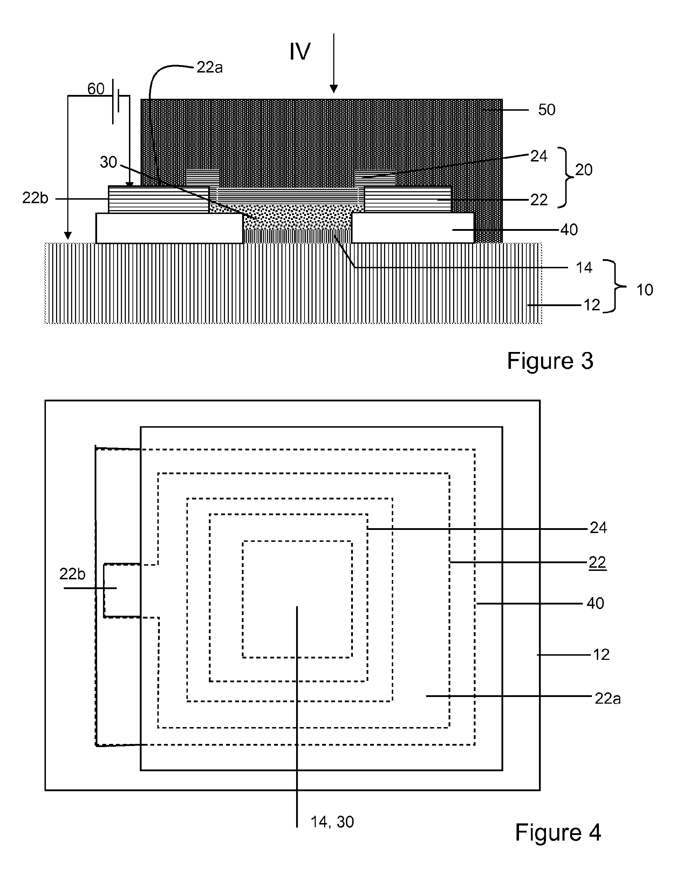

Figure 3 shows a second embodiment in cross-section. Figure 4 show a top view of this embodiment, wherein hidden parts or portions thereof are indicated by dashed lines and visible parts or portions thereof by solid lines. In the embodiment of Figure 3 the second electrically conductive structure 20 comprises in addition to the second electrode layer 24, an electric supply structure 22. This provides for more degrees of freedom in the design of the device. On the one hand for the electrical supply structure 22 materials may be used that have an excellent resistance against moisture, such as metals including aluminum and silver, but do not need to be suitable as an electrode material. On the other hand the electrode layer 24 may be manufactured from a material suitable for that purpose. However, as the electrode layer itself need not be exposed to the environment, it does not need to be moisture resistant. Accordingly also sensitive materials like Ba may be used. In particular, in the embodiment shown in Figure 3 a portion 22b of the electrically conductive structure 22 forming part of the second electrically conductive structure 20 extends laterally beyond the second electrically insulating barrier structure 50. A portion 22a of the electrically conductive structure 22 is enclosed by the second electrically insulating barrier structure 50, and electrically contacts the electrode layer 24. The active structure 30 is encapsulated by the first electrically conductive structure 10, the first electrically insulating barrier structure 40, the second electrically conductive structure 20 and the second electrically insulating barrier structure 50. In particular the electric supply structure 22 of the second electrically conductive structure 20 contributes to the encapsulation, and the electrode layer 24 of the second electrically conductive structure 20 is protected by the encapsulation. The first and the second electrically conductive structure 10, 20 are connected to respective poles of an electric power supply 60.

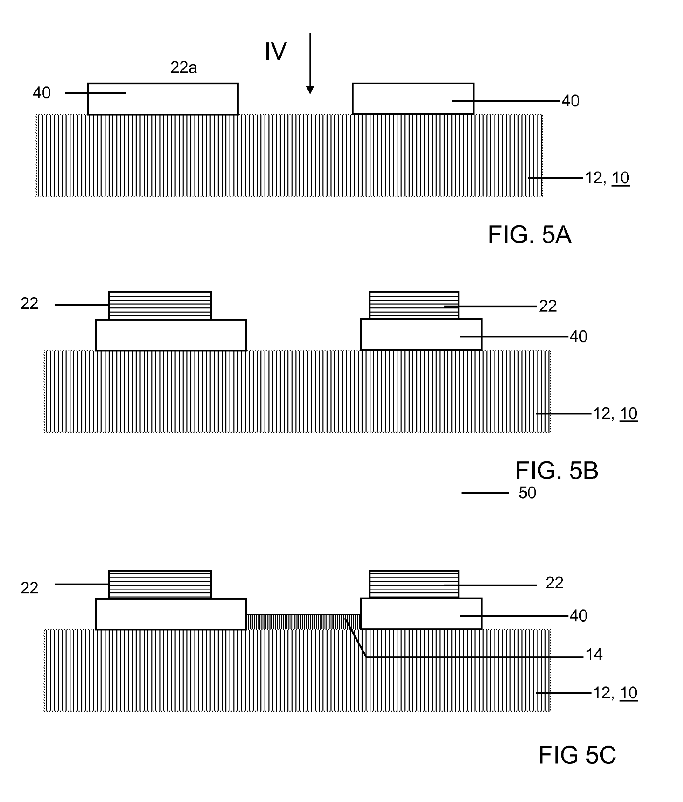

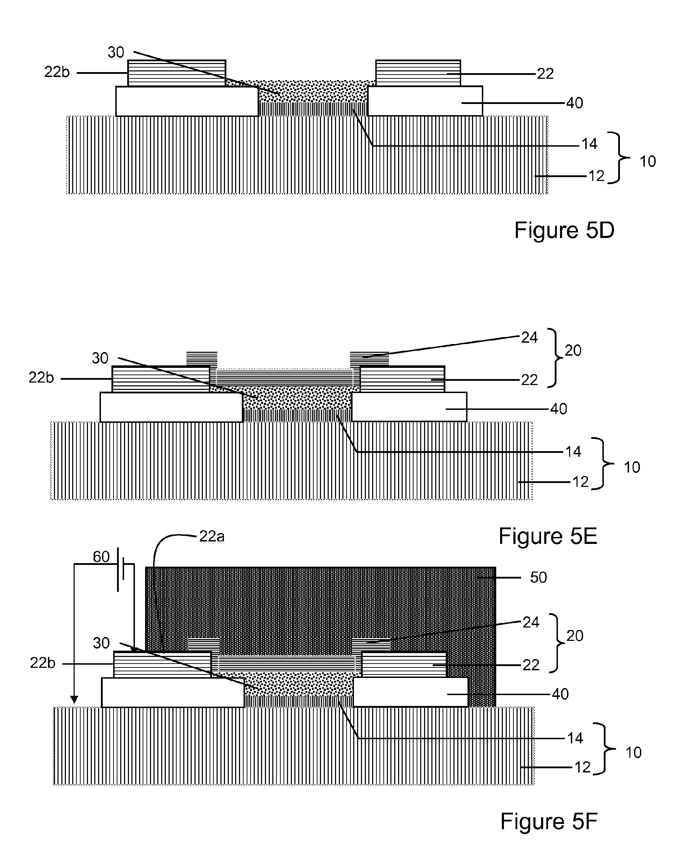

Figure 5 shows a method of manufacturing the device of Figures 3 and 4. An electrically conductive structure 10, provided with a first electrically insulating structure 40, for example with steps analogous to steps S1 and S2 illustrated in Figures 2A and 2B respectively, therewith obtaining the result shown in Figure 5A. In a subsequent step an electric supply structure 22 is applied as is shown in Figure 5B. Various options are possible to apply the electric supply structure 22, such as thermal evaporation, sputtering, printing, electroplating, after first applying a plating base, for example with electroless plating, etc.

Figure 5C shows the result of a next step, wherein a charge injection layer, e.g. a PEDOT layer 14 is applied over the first electrically conductive structure 10. This layer can be deposited using a technique that includes patterning of the layer to avoid contact with the electrical supply structure 22. If in practice the charge injection layer 14 did cover the electric supply structure 22 that forms part of the second electrically conductive structure, the effects of shortcuts should be minimized if the charge injection layer 14 is relatively thin, e.g. in the order of 10-20 nm and had a low lateral conductivity. The charge injection layer is preferably applied as a suspension by a printing method.

Figure 5D shows the result of a next step, wherein an active layer 30 is deposited. Also the active-layer is preferably deposited as a suspension by means of a printing method, such as inkjet printing, gravure printing, flexographic printing, screen printing, rotary screen printing, etc or by a coating technique such as bar coating, slot-die coating or spin coating. Although other deposition techniques such as thermal evaporation or another vapour phase deposition technique or a technique involving a carrier gas could be used.

Figure 5E shows the result of a next step, wherein the second electrode layer 24 is deposited. The second electrode layer and the electric supply structure 22 for the second electrically conductive structure 20. In addition to the second electrode layer 24 additional electrode layers may be deposited. For example an electrode layer 24 of Ba may be covered with an additional electrode layer of Al.

In a final step of which the result is shown in Figure 5F, the second electrically insulating barrier structure 50 is deposited. The electrically insulating barrier structure 50 leaves open a portion 22b of the electric supply structure 22, so that said portion 22b extends laterally beyond the second electrically insulating barrier structure 50. The second electrically insulating barrier structure 50 fully covers the second electrode structure 24. The first electrically conductive structure 10, the first electrically insulating barrier structure 40, the second electrically conductive structure 20 and the second electrically insulating barrier structure 50 form an encapsulation that encapsulates the active structure 30, and fully covers the second electrode layer 24.

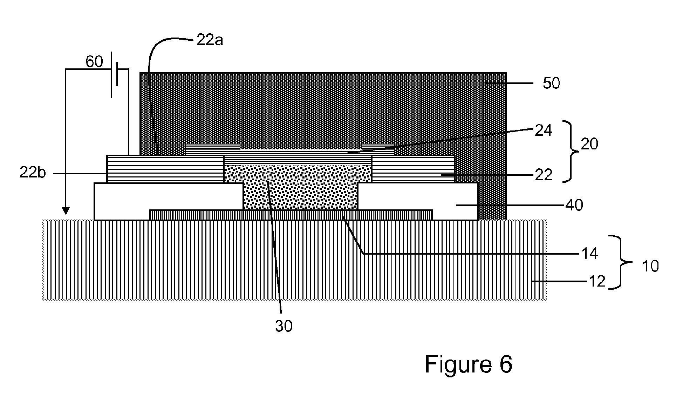

FIG. 6 shows another variant of an OLED, wherein the charge injection layer 14 is applied upon the first electrically conductive structure 10. The first electrically insulating barrier structure 40 is then applied upon the charge-injection layer 14.

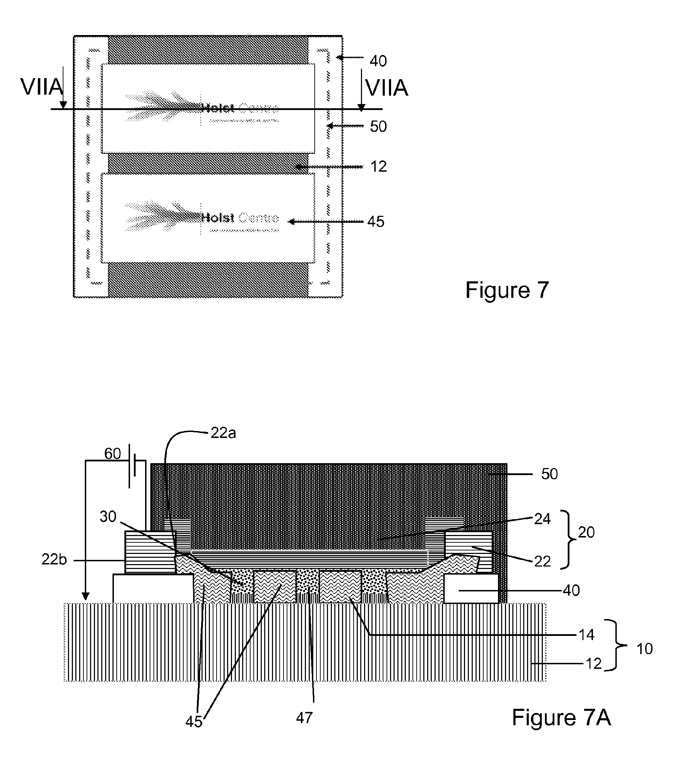

Figures 7 and 7A show an embodiment of the present invention wherein a patterned electrically insulating layer 45 is applied between the first and the second electrically conductive structure 10, 20. Figure 7A is a cross-section according to VIIA-VIIA in Figure 7. In this embodiment part of the surface of the first electrically conductive structure 10 is left free by the electrically insulating barrier layer 40 but covered by the patterned electrically insulating layer 45. The patterned electrically insulating layer 45 comprises a pattern of openings 47 through which current is conducted between the electrically conductive structures 10, 20 and through the active structure 30, so that during operation a pattern of light emission becomes visible. In the embodiment shown the patterned electrically insulating layer 45 is a patterned photoresist layer. In this way a very detailed pattern may be obtained.

Many other variants are possible. For example, contrary to the embodiments described before, the first electrode layer 12 may be a cathode layer and the second electrode layer 24 may be an anode layer.

Furthermore it is not necessary that the electronic device is an OLED. Alternatively the electronic device may be another device, such as a photovoltaic cell, or an electrochromic device.

It will be understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.
Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. A semiconductor device comprising:
- a first electrically conductive structure (10) that comprises at least a first electrode layer (12),
- a second electrically conductive structure (20) that comprises at least a second electrode layer (24),
- an active structure (30) that comprises at least a layer of an organic semiconducting material, the active structure being arranged between the first and the second electrically conductive structure (10, 20),
- an first electrically insulating barrier structure (40) that comprises at least an electrically insulating barrier layer arranged between the first and the second electrically conductive structure,
- a second electrically insulating barrier structure (50) that extends over a part of the second electrically conductive structure (20), the second electrically conductive structure (20) extending laterally beyond the second electrically insulating barrier structure (50), the active structure (30) being encapsulated by an encapsulation comprising at least the first electrically conductive structure (10), the first electrically insulating barrier structure (40), the second electrically conductive structure (20) and the second electrically insulating barrier structure (50).

2. A semiconductor device according to claim 1, wherein the second electrically conductive structure (20) further comprises an electric supply structure (22) that forms an electrical feed-through connection, having a first portion covered (22a) by the barrier structure (50) and a second portion (22b) left free by the barrier structure (50).

3. A semiconductor device according to claim 1, wherein the second electrode layer (24) forms an electrical feed-through connection.

4. A semiconductor device according to claim 1, wherein a conducting charge injection layer (14) is arranged between the first electrically conductive structure (10) and the active structure (30).

5. A semiconductor device according to claim 4, wherein the conducting charge injection layer (14) has a thickness in the range of 10 nm to 500 nm.

6. A semiconductor device according to claim 1, wherein the electrical insulator structure (40) is formed by an oxidized portion of the first electrically conductive structure (10).

7. A semiconductor device according to claim 1, wherein the first electrically insulating barrier structure (40) comprises a least one of silicon oxide (O) and silicon nitride (N).

8. A semiconductor device according to claim 7, wherein the first electrically insulating barrier structure (40) comprises a stack of alternating layers of silicon oxide (O) and silicon nitride (N).

9. A semiconductor device according to claim 1, comprising a substrate (12) that forms the first electrically conductive structure (10).

10. A semiconductor device according to claim 1, wherein a patterned electrically insulating layer (45) is applied between the first and the second electrically conductive structure (10, 20), which electrically insulating layer (45) covers a part of the surface of the first electrically conductive structure 10 that is left free by the electrically insulating barrier layer (40).

11. Method for manufacturing a semiconductor device comprising the steps of
- (S1) providing a first electrically conductive structure (10) that comprises at least a first electrode layer (12),
- (S2) providing a first electrically insulating barrier structure (40) that comprises at least an electrically insulating barrier layer on said first electrically conductive structure (10),
- (S3) depositing an active structure (30) comprising at least a layer of an organic semiconducting material at the first electrically conductive structure (10),
- (S4) depositing on the active structure (30) a second electrically conductive structure (20) that comprises at least a second electrode layer (24),
- (S5) depositing a second electrically insulating barrier structure (50) over the second electrically conductive structure (20), so that at least a portion of the second electrically conductive structure remains uncovered and forms a feed-through to the second electrode layer (24).

12. Method according to claim 11, further comprising
- providing an electric supply structure (22) that electrically contacts the second electrode layer (24) on said first electrically insulating barrier structure (40), the electric supply structure (22) and the second electrode layer (24) forming the second electrically conductive structure (20), wherein the second electrically insulating barrier structure is deposited over the second electrically conductive structure (20) so that at least a portion (22b) of the electric supply structure (22) remains uncovered and forms a feed-through to the electrode layer (24),

13. Method according to claim 11 or 12, wherein the first electrically insulating barrier structure (40) is applied by locally oxidizing the first electrically conductive structure (10).

14. Method according to claim 11, wherein the first electrically insulating barrier structure (40) is provided on said first electrically conductive structure (10), by the subsequent substeps of applying a mask layer, depositing at least one layer of an electrically insulating barrier material and removing the patterned mask layer.

15. Method according to claim 11, wherein the first electrical insulator layer structure (40) is provided on said first electrically conductive structure (10), by the subsequent substeps of applying at least one layer of an electrically insulating barrier material, applying a mask layer and etching exposed portions of the layer of insulating barrier material.
